(19) Europäisches Patentamt

European Patent Office

Office européen des brevets

(11) **EP 1 065 917 A2**

(12) **EUROPEAN PATENT APPLICATION**

(43) Date of publication:
**03.01.2001 Bulletin 2001/01**

(51) Int. Cl.[7]: **H05K 13/08, H05K 13/04**

(21) Application number: **00113695.1**

(22) Date of filing: **28.06.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **29.06.1999 JP 18430499**

(71) Applicant: **SONY CORPORATION Tokyo (JP)**

(72) Inventor:
**Yamaguchi, Minoru,**
**c/o Sony Corporation**
**Shinagawa-ku, Tokyo (JP)**

(74) Representative:
**MÜLLER & HOFFMANN Patentanwälte**
**Innere Wiener Strasse 17**
**81667 München (DE)**

(54) **Calibrating method for part mounting apparatus**

(57)    A calibrating method for a part mounting apparatus including a support table on which a mounting board is supported, a part supply portion, a mounting head, a part recognition portion for detecting the position of an electrical part in the part supply portion, and a board recognition portion provided to the mounting head so as to detect the position of the mounting board on the support table, comprises a first step for calibrating the coordinate system of the part recognition portion on the basis of the coordinate system of the mounting head, a second step for calibrating the coordinate system of the board recognition portion on the basis of the coordinate system of the mounting head, a third step for calibrating the coordinate system of the reference board on the basis of the coordinate system of the mounting head, a fourth step for calibrating the coordinate system of the fixed recognition portion on the basis of the coordinate system of the mounting head, and a fifth step for calculating the rotational center position of the mounting head.

FIG.2

START

CALIBRATION 1 OF ROBOT COORDINATE SYSTEM r AND FIXED CAMERA COORDINATE SYSTEM f — ST1

CALIBRATION OF ROBOT COORDINATE SYSTEM r AND BOARD CAMERA COORDINATE SYSTEM p — ST2

CALIBRATION OF ROBOT COORDINATE SYSTEM R AND REFERENCE BOARD COORDINATE SYSTEM s — ST3

CALIBRATION 2 OF ROBOT COORDINATE SYSTEM r AND FIXED CAMERA COORDINATE SYSTEM f — ST4

CALCULATION OF DISTANCE FROM FIXED CAMERA TO ROTATION CENTER OF MOUNTING HEAD — ST5

END

EP 1 065 917 A2

**Description**

BACKGROUND OF THE INVENTION

1. Field of the Invention

The present invention relates to a part mounting apparatus for mounting an electrical part on a mount board such as a print board, and particularly to a calibrating method for correcting the position of the part mounting apparatus.

2. Description of the Related Art

A part mounting apparatus has been hitherto used when an electrical part is mounted on a mount board such as a print board.

Such a part mounting apparatus contains a support table for supporting a mount board, a part supply portion for successively supplying electrical parts, and a mounting head for feeding the electrical part from the part supply portion to a predetermined position of the mount board on the support table.

According to the part mounting apparatus thus constructed, the electrical parts are successively fed from the part supply portion to predetermined positions of the mount board and mounted at the respective positions by the mounting head, thereby performing the mounting of the electrical parts.

Here, in order for the mounting head to accurately feed an electrical part to a predetermined position on the mount board, it is necessary to correct the horizontal two directions, that is, the X direction and the Y direction and the rotational direction on the XY plane of the mounting head relatively to the mount board.

As an example, according to a coordinate correcting method for a visual recognition apparatus disclosed in Japanese Laid-open Patent Application Sho-63-300843 previously filed by the applicant of this application (at present, Japanese Patent No. 2707548 owned by the applicant of this application), in a positioning apparatus such as a numerical control apparatus having a visual recognition apparatus, the coordinate system of the visual recognition apparatus and the coordinate system of the positioning apparatus are made coincident with each other to enable the coordinate of a recognition target to be handled in the same coordinate system.

Conventionally, after the mounting head, the support table for supporting the mount board, etc. are individually and separately designed and manufactured, they are assembled with one another and constructed as a part mounting apparatus. Therefore, in order to achieve a desired part mounting precision, it is necessary that after a prototype of a part mounting apparatus is formed to measure the mounting precision thereof, the prototype is re-designed because the mounting precision in the completed part mounting apparatus cannot be estimated in the design step. Therefore, there is a problem that the development time of the part mounting apparatus is long and the development cost is increased.

Further, since it is necessary to propose a calibrating method supporting the part mounting apparatus concerned and ensure the mounting precision every time a novel part mounting apparatus is developed, there is a problem that the development cost of the part mounting apparatus is further increased.

OBJECTS AND SUMMARY OF THE INVENTION

In view of the foregoing description, the present invention has an object to provide a widely usable calibrating method which can enhance the mounting precision and can be easily developed by systematizing the calibration of the mounting position of the mounting head with respect to the mount board.

According to the present invention, there is provided a calibrating method for a part mounting apparatus including a support table for supporting a mount board thereon, a part supply portion for successively supplying electrical parts, a mounting head for feeding an electrical part from the part supply portion to a predetermined position of the mount board on the support table, a part recognition portion which is fixedly disposed so as to detect the position of an electrical part in the part supply portion on the basis of image recognition, and a board recognition portion which is provided to the mounting head so as to detect the position of the mount board on the support table on the basis of image recognition, which is characterized by comprising: a first step for calibrating the coordinate system of the part recognition portion on the basis of the coordinate system of the mounting head; a second step for calibrating the coordinate system of the board recognition portion on the basis of the coordinate system of the mounting head; a third step for calibrating the coordinate system of a reference board on the basis of the coordinate system of the mounting head; a fourth step for correcting the origin of the coordinate system of the part recognition portion on the basis of the coordinate system of the mounting head; and a fifth step for calculating the rotational center position of the mounting head.

According to the construction of the present invention, the coordinate systems of the part recognition portion, the board recognition portion, the fixed recognition portion and the reference board are calibrated on the basis of the coordinate system of the mounting head in the process from the first step to the fourth step, and also the rotational center position of the mounting head in the coordinate system of the part recognition portion is calculated in the fifth step, whereby the calibration of each coordinate system on the basis of the coordinate system of the mounting head is performed.

Accordingly, the calibration of the part mounting apparatus can be systematized by calibrating each coordinate system on the basis of the coordinate system of the mounting head, so that the final apparatus precision can be easily estimated in the design step of the part mounting apparatus and thus desired mounting precision can be surely achieved. In addition, it is a widely usable calibration method which can support new models, so that the developing time of the new models of the part mounting apparatuses can be shortened and the development cost can be reduced.

Further, since a calibration-contributed portion and a calibration non-contributed portion can be clearly discriminated from each other, a portion to which the mechanical design precision is required in the part mounting apparatus and a portion to which no mechanical design precision is required in the part mounting apparatus are clearly discriminated from each other. Accordingly, the manufacturing cost of the part mounting apparatus can be reduced.

BRIEF DESCRIPTION OF THE DRAWINGS

Fig. 1 is a schematic diagram showing the construction of a part mounting apparatus to which a calibration method of the present invention is applied;
Fig. 2 is a flowchart showing an embodiment of the calibration method according to the present invention;
Fly. 3 is a schematic diagram showing the relationship between a robot coordinate system r and a board camera coordinate system p in the part mounting apparatus of Fig. 1;
Fig. 4 is a schematic diagram showing the relationship between the robot coordinate system r and an NC coordinate system nc in the part mounting apparatus of Fig. 1;
Fig. 5 is a schematic diagram showing the relationship between the robot coordinate system r and the fixed camera coordinate system f, the board camera coordinate system p and the reference board coordinate system s in the part mouting apparatus of Fig.1;
Fig. 6 is a flowchart showing the operation of the part mounting in the part mounting apparatus of Fig. 1;
Fig. 7 is a schematic diagram showing the rotational correction of an electrical part in the part mounting apparatus of Fig. 1 when it is mounted; and
Fig. 8 is a schematic diagram showing the rotational correction of the electrical part and the displacement of the center position in the part mounting apparatus of Fig. 1 when the part is mounted;

DETAILED DESCRIPTION OF THE PREFERRED EMBODIMENTS

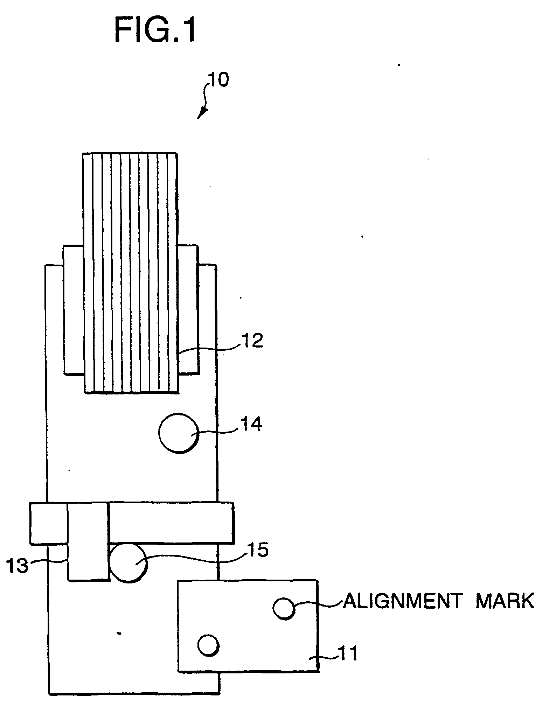

Preferable embodiments of the present invention will be described in detail with reference to Figs. 1 to 8.

The following embodiments are preferable embodiments of the present invention, and thus various technically preferable limitations are imposed on these embodiments. However, the scope of the present invention is not limited to these embodiments unless such a description as to limit the present invention is particularly made in the following description.

Fig. 1 shows the construction of a part mounting apparatus to which a calibration method according to an embodiment of the present invention is applied.

In Fig. 1, the part mounting apparatus 10 includes a mount board 11 supported on a support table (not shown), a part supply portion 12 for successively supplying electrical parts, a mounting head (robot head) 13 for feeding an electrical part from the part supply portion 12 to a predetermined position of the mount board 11 on the support table, a fixed camera 14 serving as a part recognition portion which is fixedly disposed so as to detect the position of the electrical part in the part supply portion 12 on the basis of image recognition, and a board camera 15 serving as a board recognition portion provided to the mounting head 13 so as to detect the position of the mount board 11 on the support table on the basis of the image recognition.

The part supply portion 12 is designed to successively supply electrical parts to be mounted on the mount board 11. The mounting head 13 holds an electrical part to be mounted under vacuum suction or by other means in the part supply portion 12 and feeds it to a predetermined position on the mounting board 11.

The fixed camera 14 comprises a CCD camera or the like, and it is fixed to the base portion of the main body of the part mounting apparatus 10 to recognize the electrical part held on the mounting head 13 under vacuum suction.

The board camera 15 comprises a CCD camera or the like. It is secured to the mounting head 13 and recognizes an alignment mark on the mounting board 11 to measure the position and angle of the mounting board 11.

Here, for the part mounting apparatus 10 described above exist the following five coordinate systems, that is, a robot coordinate system r, a fixed camera coordinate system f, a board camera coordinate system p, an NC coordinate system nc and a reference board coordinate system s.

That is, for example when a controller (not shown) for controlling the driving of the operating portions such as the part supply portion 12, the mounting head (robot head) 13, the fixed camera 14, the board camera 15 of the part mouting apparatus 10 is constructed by a processor such as a computer, for example when the control of the driving is carried out by using software, the above respective coordinate systems are set on the software and the processing described later can be performed.

First, the robot coordinate system r is a coordinate system on the plane parallel to the mounting board 11 when the mounting head 13 (robot head) operates in the X-direction and the Y-direction, and the position of the origin generally has a fixed offset from the position at which the origin locating operation is carried out.

The position at which the origin locating operation is carried out is defined as a position at which, when a reference point is detected by some sensor, the Z-layer waveform is first detected from the reference point.

In this case, the control of the mounting head is carried out on the basis of a control pulse number supplied to a driving pulse motor, however, the relationship between the pulse number and the distance (mm) is known with respect to the coordinate position in the robot coordinate system r.

Accordingly, mm is used as the unit of the robot coordinate system r. In the robot coordinate system r, when the mounting head 13 is viewed from the front of Fig. 1, the direction to the right is set as X+ and the direction to the depth is set as Y+.

Next, the fixed camera coordinate system f is a coordinate system in the visual field of the camera which is settled on the angle of view of the fixed camera 14. In general, the left upper corner on the screen corresponds to the origin, and the unit of the coordinate system is a picture element (pixel). With respect to the screen, the right direction from the origin at the left upper corner is set as X+, and the down direction therefrom is set as Y+.

Like the fixed camera coordinate system, the board camera coordinate system p is a coordinate system in the visual field of the camera which is settled on the angle of view of the board camera 15, and the left upper corner of the screen generally corresponds to the origin. The unit of the coordinate system is a picture element (pixel). With respect to the screen, X+ is set to the right direction from the origin at the left upper corner, and Y+ is set to the down direction from the origin.

The NC coordinate system nc is a coordinate system for giving part mount position data created at the time of the board design. It generally uses the left lower corner of the board or a reference pin provided to the board as the origin, and X+ is set to the right direction from the position of the origin while Y+ is set to the up direction from the position of the origin.

Finally, the reference board coordinate system s is a coordinate system for an ideal mounting board fed onto the support table, and the relationship between it and the robot coordinate system r is settled by a jig board or the like.

In the case shown in the figure, the left lower corner of the reference board is set as the origin, and X+ is set to the right direction from the position of the origin while Y+ is set to the up direction from the position of the origin.

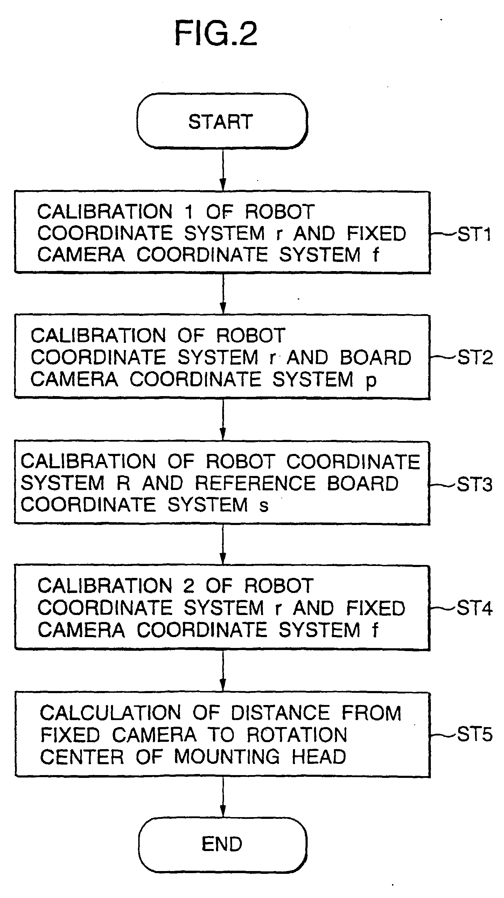

According to an embodiment of the calibrating method of the present invention, the relationship among these coordinate systems is calibrated as shown in the flowchart of Fig. 2.

In the flowchart of Fig. 2, the calibration of the robot coordinate system r and the fixed camera coordinate system f is first carried out in step ST1.

The calibration of the robot coordinate system r and the fixed camera coordinate system f is carried out specifically as described below.

First, a recognition target such as a recognizable sphere is mounted under suction by the mounting head 13 of the part mounting apparatus 10. The recognition target is moved within the visual field of the fixed camera 14, and the mounting head 13 is operated so that the recognition target is located at three points which are not on any straight line. The recognition target is recognized at the respective three points.

Accordingly, representing any three points by $(X_1, Y_1)$, $(X_2, Y_2)$, $(X_3, Y_3)$, the following three matrix equations are satisfied at the respective three points.

[Equation 1]

$$\begin{bmatrix} X_1 \\ Y_1 \\ 1 \end{bmatrix}_r = \begin{bmatrix} a & b & \beta x \\ c & d & \beta y \\ 0 & 0 & 1 \end{bmatrix} \cdot \begin{bmatrix} X_1 \\ Y_1 \\ 1 \end{bmatrix}_f \quad \cdots\cdots(1)$$

[Equation 2]

$$\begin{bmatrix} X_2 \\ Y_2 \\ 1 \end{bmatrix}_r = \begin{bmatrix} a & b & \beta x \\ c & d & \beta y \\ 0 & 0 & 1 \end{bmatrix} \bullet \begin{bmatrix} X_2 \\ Y_2 \\ 1 \end{bmatrix}_f \quad \cdots\cdots (2)$$

[Equation 3]

$$\begin{bmatrix} X_3 \\ Y_3 \\ 1 \end{bmatrix}_r = \begin{bmatrix} a & b & \beta x \\ c & d & \beta y \\ 0 & 0 & 1 \end{bmatrix} \bullet \begin{bmatrix} X_3 \\ Y_3 \\ 1 \end{bmatrix}_f \quad \cdots\cdots (3)$$

Here, $\beta x$, $\beta y$ represent the offset between the robot coordinate system and the fixed camera coordinate system, respectively.

Further, from the fact that the three points are not located on the straight line, the following relationship is established:

[Equation 4]

$$\begin{bmatrix} X_1 \\ Y_2 \\ X_3 \end{bmatrix}_r = \begin{bmatrix} X_1 & Y_1 & 1 \\ X_2 & Y_2 & 1 \\ X_3 & Y_3 & 1 \end{bmatrix}_f \bullet \begin{bmatrix} a \\ b \\ \beta x \end{bmatrix}$$

By solving this equation with respect to a,b,$\beta x$, the following equation is obtained.

[Equation 5]

$$\therefore \begin{bmatrix} a \\ b \\ \beta x \end{bmatrix} = \begin{bmatrix} X_1 & Y_1 & 1 \\ X_2 & Y_2 & 1 \\ X_3 & Y_3 & 1 \end{bmatrix}_f^{-1} \bullet \begin{bmatrix} X_1 \\ X_2 \\ X_3 \end{bmatrix}_r \quad \cdots\cdots (4)$$

Further, the following relationship is satisfied:

**[Equation 6]**

$$\begin{bmatrix} Y_1 \\ Y_2 \\ Y_3 \end{bmatrix}_r = \begin{bmatrix} X_1 & Y_1 & 1 \\ X_2 & Y_2 & 1 \\ X_3 & Y_3 & 1 \end{bmatrix}_f \cdot \begin{bmatrix} c \\ d \\ \beta y \end{bmatrix}$$

By solving the above equation with respect to c,d,βy, the following equation is obtained:

**[Equation 7]**

$$\therefore \begin{bmatrix} c \\ d \\ \beta y \end{bmatrix} = \begin{bmatrix} X_1 & Y_1 & 1 \\ X_2 & Y_2 & 1 \\ X_3 & Y_3 & 1 \end{bmatrix}_f^{-1} \cdot \begin{bmatrix} Y_1 \\ Y_2 \\ Y_3 \end{bmatrix}_r \quad \cdots\cdots(5)$$

Accordingly, from the (equation 1) to (equation 5), the calibrating matrix based on the robot coordinate system for the fixed camera 14 for part recognition is determined:

**[Equation 8]**

$$\begin{bmatrix} X \\ Y \\ 1 \end{bmatrix}_r = \begin{bmatrix} a & b & \beta x \\ c & d & \beta y \\ 0 & 0 & 1 \end{bmatrix} \cdot \begin{bmatrix} X \\ Y \\ 1 \end{bmatrix}_f \quad \cdots\cdots(6)$$

Here, $\beta x$, $\beta y$ represent the offset between the robot coordinate system and the fixed camera coordinate system, and it does not express the relationship with the mounting head. Accordingly, by calculating the recognition result of the fixed camera 14 on the assumption that $\beta x = \beta y = 0$ , the calculation result indicates the position on the coordinate system which is parallel to the robot coordinate system and has the origin of the fixed camera as an origin.

Subsequently, the calibration of the robot coordinate system r and the board camera coordinate system p is carried out in step ST2 of the flowchart of Fig. 2.

The calibration of the robot coordinate system r and the board camera coordinate system p is carried out specifically as described below.

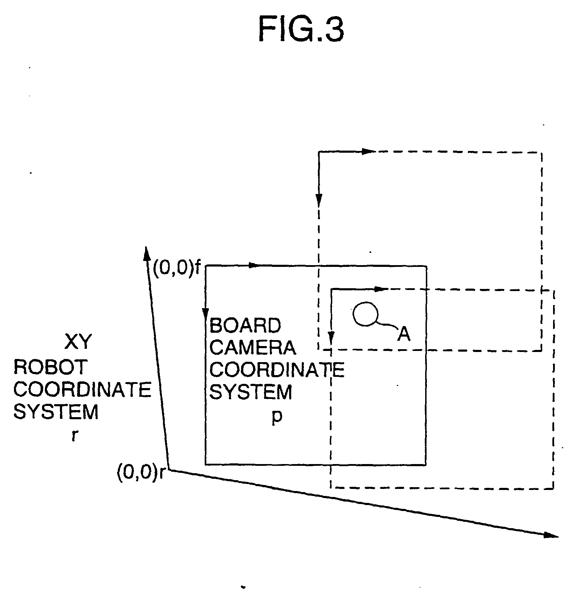

Since the board camera 15 is secured to the mounting head 13, the visual field thereof is moved while the mounting head 13 is moved. Accordingly, as shown in Fig. 3, any fixed point A on the mounting board 11 is recognized at any three places so that it enters the visual field of the board camera 15 by moving the board camera 15.

Accordingly, likewise, from the three matrix equations at any three points and under the condition that the three points are not located on one straight line, the same equation as the equation (6) can be obtained.

[Equation 9]

$$\begin{bmatrix} X \\ Y \\ 1 \end{bmatrix}_r = \begin{bmatrix} e & f & \beta x \\ g & h & \beta y \\ 0 & 0 & 1 \end{bmatrix} \cdot \begin{bmatrix} X \\ Y \\ 1 \end{bmatrix}_p \quad \cdots\cdots (7)$$

Here, assuming that the origin of the robot coordinate system r is coincident with the origin of the board camera coordinate system p at the position of the origin of the mounting head 13, it is satisfied that $\beta x = \beta y = 0$ , and if the mounting head 13 is located at any position $(\beta x, \beta y)$, the position which is recognized on the basis of the board camera coordinate system p by the board camera 15 is determined from the equation (7) on the basis of the robot coordinate system r.

Further, the calibration of the robot coordinate system r and the reference board coordinate system s is carried out in step ST3 of the flowchart of Fig. 2.

The calibration of the robot coordinate system r and the reference board coordinate systems is carried out specifically as described below.

First, three known points on the reference board (jig board for calibration) fed onto the support table are successively recognized by the board camera 15.

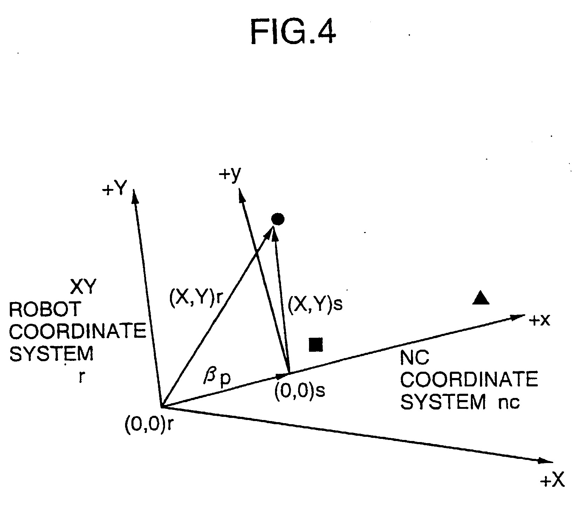

This recognition result is obtained as a point $(X,Y)_r$ on the robot coordinate system r from the equation (7). As shown in Fig. 4, the three points are known on the reference board coordinate system s, and thus assuming that the origin offset of these two coordinate systems is represented by $\beta p$ $(\beta px, \beta py)$, the following three equations are obtained:

[Equation 10]

$$\begin{bmatrix} X1 \\ Y1 \\ 1 \end{bmatrix}_s = \begin{bmatrix} ap & bp & \beta px \\ cp & dp & \beta py \\ 0 & 0 & 1 \end{bmatrix} \cdot \begin{bmatrix} X1 \\ Y1 \\ 1 \end{bmatrix}_r \quad \cdots\cdots (8)$$

[Equation 11]

$$\begin{bmatrix} X2 \\ Y2 \\ 1 \end{bmatrix}_s = \begin{bmatrix} ap & bp & \beta px \\ cp & dp & \beta py \\ 0 & 0 & 1 \end{bmatrix} \cdot \begin{bmatrix} X2 \\ Y2 \\ 1 \end{bmatrix}_r \quad \cdots\cdots (9)$$

[Equation 12]

$$\begin{bmatrix} X3 \\ Y3 \\ 1 \end{bmatrix}_s = \begin{bmatrix} ap & bp & \beta px \\ cp & dp & \beta py \\ 0 & 0 & 1 \end{bmatrix} \cdot \begin{bmatrix} X3 \\ Y3 \\ 1 \end{bmatrix}_r \quad \cdots\cdots (10)$$

Here, $(X,Y)_s$ represents the position of the NC coordinate system (unit mm), and $(X,Y)_r$ represents the position of the robot coordinate system (unit mm).

Further, since the three points are not located on the straight line, the following relationship is satisfied:

**[Equation 13]**

$$\begin{bmatrix} X1 \\ X2 \\ X3 \end{bmatrix}_s = \begin{bmatrix} X1 & Y1 & 1 \\ X2 & Y2 & 1 \\ X3 & Y3 & 1 \end{bmatrix}_r \cdot \begin{bmatrix} ap \\ bp \\ \beta px \end{bmatrix}$$

By solving the above equation with respect to ap, bp, $\beta$px, the following relationship is satisfied:

**[Equation 14]**

$$\therefore \begin{bmatrix} ap \\ bp \\ \beta px \end{bmatrix} = \begin{bmatrix} X1 & Y1 & 1 \\ X2 & Y2 & 1 \\ X3 & Y3 & 1 \end{bmatrix}_r^{-1} \cdot \begin{bmatrix} X1 \\ X2 \\ X3 \end{bmatrix}_s \quad \cdots\cdots (11)$$

Further, the following relationship is satisfied:

**[Equation 15]**

$$\begin{bmatrix} Y1 \\ Y2 \\ Y3 \end{bmatrix}_s = \begin{bmatrix} X1 & Y1 & 1 \\ X2 & Y2 & 1 \\ X3 & Y3 & 1 \end{bmatrix}_r \cdot \begin{bmatrix} cp \\ dp \\ \beta py \end{bmatrix}$$

By solving the above equation with respect to cp, dp, $\beta$py, the following relationship is satisfied:

**[Equation 16]**

$$\therefore \begin{bmatrix} cp \\ dp \\ \beta py \end{bmatrix} = \begin{bmatrix} X1 & Y1 & 1 \\ X2 & Y2 & 1 \\ X3 & Y3 & 1 \end{bmatrix}_r^{-1} \cdot \begin{bmatrix} Y1 \\ Y2 \\ Y3 \end{bmatrix}_s \quad \cdots\cdots (12)$$

Accordingly, from the equation (8) to the equation (12), the following calibrating matrix based on the robot coordinate system r for the reference board coordinate system s (the NC coordinate system nc) is determined:

[Equation 17]

$$\begin{bmatrix} X \\ Y \\ 1 \end{bmatrix}_s = \begin{bmatrix} ap & bp & \beta px \\ cp & dp & \beta py \\ 0 & 0. & 1 \end{bmatrix} \cdot \begin{bmatrix} X \\ Y \\ 1 \end{bmatrix}_r \quad \cdots\cdots (13)$$

With the above equation, the distortion, inclination and magnification of the robot coordinate system r to the NC coordinate system nc are calibrated.

Subsequently, the second calibration of the robot coordinate system r and the fixed camera coordinate system f is carried out in step ST4 of the flowchart of Fig. 2.

The calibration of the robot coordinate system r and the fixed camera coordinate system f is aimed to determine the position of the origin of the fixed camera 15 on the robot coordinate system r, and it is carried out specifically as follows.

First, one recognition hole formed on the support table by the board jig is recognized by the fixed camera 14 and the board camera 15. When the recognition result of each camera 14, 15 is converted to the robot coordinate system r by the equations 6 and 7, the position of the origin $(Xc, Yc)_r$ of the fixed camera 14 on the robot coordinate system r is represented as follows:

[Equation 18]

$$\begin{bmatrix} X_c \\ Y_c \\ 1 \end{bmatrix}_r = \begin{bmatrix} X_f \\ Y_f \\ 1 \end{bmatrix}_r - \begin{bmatrix} X_d \\ Y_d \\ 1 \end{bmatrix}_r$$

$$= \begin{bmatrix} a & b & \beta x \\ c & d & \beta y \\ 0 & 0 & 1 \end{bmatrix} \cdot \begin{bmatrix} X \\ Y \\ 1 \end{bmatrix}_f - \begin{bmatrix} e & f & 0 \\ g & h & 0 \\ 0 & 0 & 1 \end{bmatrix} \cdot \begin{bmatrix} X \\ Y \\ 1 \end{bmatrix}_d \quad \cdots\cdots (14)$$

The position based on the robot coordinate system r can be also determined not by the board camera 15, but by the conversion from the reference board coordinate system s. In this case, the position based on the robot coordinate system r is determined from the equation (13) ( it is required that the position of the recognition hole is accurately given on the reference board coordinate system s).

Finally, the distance from the fixed camera 14 to the rotational center position of the mounting head is calculated in step ST5 of the flowchart of Fig. 2.

This is specifically carried out as follows.

First, a recognition target having many points which can be used as measurement points such as QFP is mounted under suction by the mounting head. The recognition of the recognition target is carried out by the part camera 14 while the mounting head 13 is rotated at an angular interval of several degrees by 360 degrees. At this time, the part camera 14 is moved to the position of the robot coordinate system which is obtained by substituting $(0,0,1)_p$ into the equation (7), whereby the center of the mounting head 13 is moved substantially to the center of the visual field of the part camera 14.

With this operation, the recognition target in the visual field of the part camera 14 and the position of the rotational center of the mounting head 13 are determined. By matching the rotational center of the mounting head 13 to the center of the visual field of the part camera 14, the recognition result of an electrical part by the part camera 14 is directly used as a rotational radius in the rotation correction step of the electrical part.

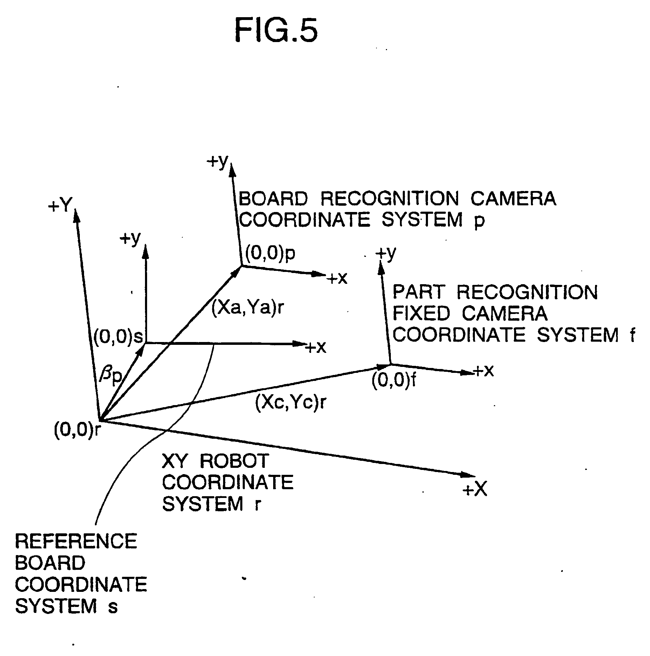

As described above, the fixed camera coordinate system f, the board camera coordinate system p and the reference board coordinate system s (NC coordinate system nc) are calibrated by the robot coordinate system r as shown in Fig. 5, and the conversion between each coordinate system and the robot coordinate system r is carried out on the following equations, and then the calibration is completed.

For the fixed camera coordinate system f,

[Equation 19]

$$\begin{bmatrix} X \\ Y \\ 1 \end{bmatrix}_r = \begin{bmatrix} a & b & \beta x \\ c & d & \beta y \\ 0 & 0 & 1 \end{bmatrix} \bullet \begin{bmatrix} X \\ Y \\ 1 \end{bmatrix}_f \quad \cdots\cdots (15)$$

for the reference board coordinate system s,

[Equation 20]

$$\begin{bmatrix} X \\ Y \\ 1 \end{bmatrix}_s = \begin{bmatrix} ap & bp & \beta px \\ cp & dp & \beta py \\ 0 & 0 & 1 \end{bmatrix} \bullet \begin{bmatrix} X \\ Y \\ 1 \end{bmatrix}_r \quad \cdots\cdots (16)$$

and for the board camera coordinate system p,

[Equation 21]

$$\begin{bmatrix} X \\ Y \\ 1 \end{bmatrix}_r = \begin{bmatrix} e & f & X_c \\ g & h & Y_c \\ 0 & 0 & 1 \end{bmatrix} \bullet \begin{bmatrix} X \\ Y \\ 1 \end{bmatrix}_P \quad \cdots\cdots (17)$$

Subscripts represent the following coordinate systems.

r: XY robot coordinate system
p: camera coordinate system for board recognition
s: reference board coordinate system
f: camera coordinate system for part recognition
βp: the offset in origin between XY robot coordinate system and reference board coordinate system

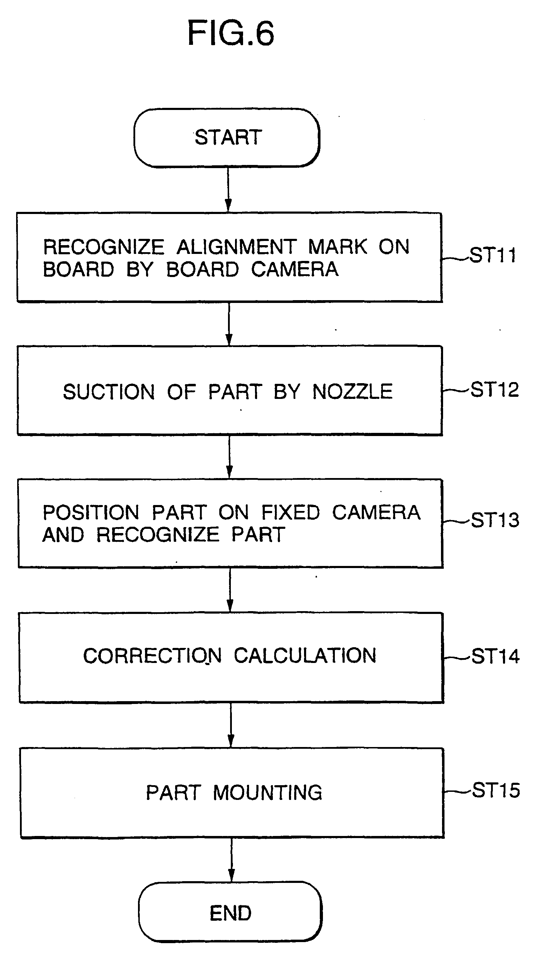

When a mount part is mounted by the part mounting apparatus 10 for which the calibration based on the robot coordinate system for each coordinate system is carried out, the mounting operation shown in the flowchart of Fig. 6 is carried out.

In the flowchart of Fig. 6, an alignment mark on the mounting board 11 is first recognized by the board camera 15 mounted on the mounting head 13 in step ST11.

That is, the mounting board 11 is fed to and set up at a predetermined position on the support table 11, and then two known alignment marks $(Xn1, Yn1)_{nc}$, $(Xn2, Yn2)_{nc}$ are recognized in the NC coordinate system nc by the board camera 15. When the board camera 15 is moved to the recognition position, the reference board coordinate system s is used.

Here, assuming that the recognition result indicates $(Xr1, Yr1)_p$, $(Xr2, Yr2)_p$, the following equations are obtained from $(Xr1, Yr1)_p$ from the equation (17) as shown in Fig. 6:

**[Equation 22]**

$$\begin{bmatrix} Xr1 \\ Yr1 \\ 1 \end{bmatrix}_r = \begin{bmatrix} e & f & \beta x \\ g & h & \beta y \\ 0 & 0 & 1 \end{bmatrix} \cdot \begin{bmatrix} Xr1 \\ Yr1 \\ 1 \end{bmatrix}_P \quad \cdots\cdots (18)$$

**[Equation 23]**

$$\begin{bmatrix} Xr1 \\ Yr1 \\ 1 \end{bmatrix}_s = \begin{bmatrix} ap & bp & \beta px \\ cp & dp & \beta py \\ 0 & 0 & 1 \end{bmatrix} \cdot \begin{bmatrix} Xr1 \\ Yr1 \\ 1 \end{bmatrix}_r \quad \cdots\cdots (19)$$

$(Xr2, Yr2)_p$ can be also converted to the reference board coordinate system s in the same manner. Here, assuming that both the NC coordinate system nc and the reference board coordinate system s are orthogonal coordinate systems and the aspect ratio is 1:1,

**[Equation 24]**

$$\begin{bmatrix} Xr1 \\ Yr1 \\ 1 \end{bmatrix}_s = \begin{bmatrix} a & -b & \beta x \\ b & a & \beta y \\ 0 & 0 & 1 \end{bmatrix} \cdot \begin{bmatrix} Xn1 \\ Yn1 \\ 1 \end{bmatrix}_{nc} \quad \cdots\cdots (20)$$

**[Equation 25]**

$$\begin{bmatrix} Xr2 \\ Yr2 \\ 1 \end{bmatrix}_s = \begin{bmatrix} a & -b & \beta x \\ b & a & \beta y \\ 0 & 0 & 1 \end{bmatrix} \cdot \begin{bmatrix} Xn2 \\ Yn2 \\ 1 \end{bmatrix}_{nc} \quad \cdots\cdots (21)$$

From (equation 20 - equation 21),

[Equation 26]

$$\begin{bmatrix} Xr1 - Xr2 \\ Yr1 - Yr2 \\ 0 \end{bmatrix}_s = \begin{bmatrix} a & -b & \beta x \\ b & a & \beta y \\ 0 & 0 & 1 \end{bmatrix} \bullet \begin{bmatrix} Xn1 - Xn2 \\ Yn1 - Yn2 \\ 0 \end{bmatrix}_{nc}$$

[Equation 27]

$$\begin{bmatrix} Xr1 - Xr2 \\ Yr1 - Yr2 \\ 0 \end{bmatrix}_s = \begin{bmatrix} Xn1 - Xn2 & -Yn1 + Yn2 & 0 \\ Yn1 - Yn2 & Xn1 - Xn2 & 0 \\ 0 & 0 & 1 \end{bmatrix} \bullet \begin{bmatrix} a \\ b \\ 0 \end{bmatrix}_{nc}$$

[Equation 28]

$$\therefore \begin{bmatrix} a \\ b \\ 0 \end{bmatrix}_{nc} = \begin{bmatrix} Xn1 - Xn2 & -Yn1 + Yn2 & 0 \\ Yn1 - Yn2 & Xn1 - Xn2 & 0 \\ 0 & 0 & 1 \end{bmatrix}^{-1} \bullet \begin{bmatrix} Xr1 - Xr2 \\ Yr1 - Yr2 \\ 0 \end{bmatrix}_s \quad \cdots\cdots(22)$$

$\beta$ is determined by substituting the above equation into the equation 20 or 21, and the matrix for converting the NC coordinate system nc to the reference board coordinate system is determined:

[Equation 29]

$$\begin{bmatrix} Xr \\ Yr \\ 1 \end{bmatrix}_s = \begin{bmatrix} a & -b & \beta x \\ b & a & \beta y \\ 0 & 0 & 1 \end{bmatrix} \bullet \begin{bmatrix} Xn \\ Yn \\ 1 \end{bmatrix}_{nc} \quad \cdots\cdots(23)$$

Here, the rotational angle $\theta_p$ of the mounting board 11 is as follows:

[Equation 30]

$$\theta p = \tan^{-1} \frac{b}{a} \quad\quad (24)$$

Subsequently, in step ST12, a mount target electrical part in the part supply portion 12 is mounted under suction by the suction nozzle of the mounting head 13, and in step ST13 the electrical part concerned is positioned onto the fixed camera 14 and then recognized by the fixed camera 14.
Thereafter, the correcting calculation is carried out in step ST14.

In this case, the correction angle $\theta$ is represented as follows, wherein the inclination of the electrical part when it is actually mounted under suction and recognized by the fixed camera is represented by $\theta d$, and the position of the electrical part is represented by $(Xd, Yd)_f$, and a target angle is represented $\theta a$.

[Equation 31]

$$\theta = \theta a + \theta d - \theta p \qquad (25)$$

$\theta p$ represents the angle in the board coordinate system (right-hand coordinate system), and the others represent the angles in the fixed camera coordinate system f (left-hand coordinate system).

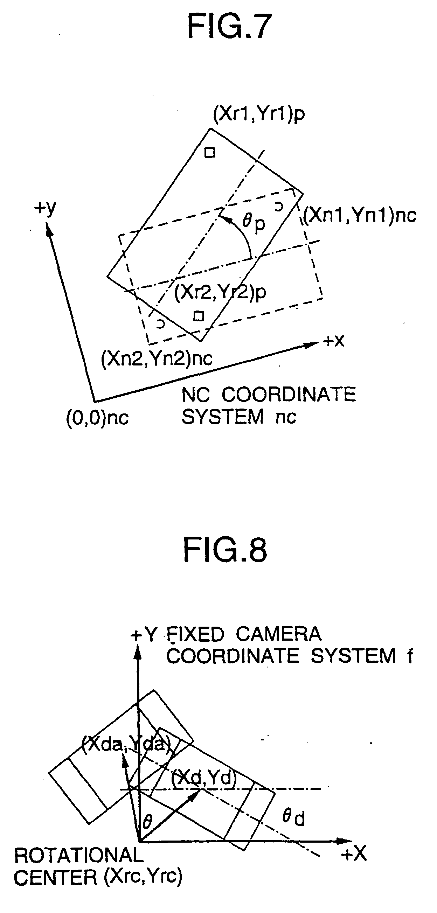

Here, since the rotational center of the mounting head is not coincident with the center of the part concerned, the position $(Xd, Yd)_f$ is also displaced when the electrical part concerned is rotated by the correction angle $\theta$ as shown in Fig. 7. Since the rotational center position is coincident with the screen center of the fixed camera 14 and the origin of the fixed camera 14 as shown in Fig. 8, on the assumption of this coincidence, the position-corrected position $(Xda, Yda)_f$ when the electrical part is subjected to the rotational correction on the fixed camera coordinate system f is given from the following equation:

[Equation 32]

$$\begin{bmatrix} Xda \\ Yda \\ 1 \end{bmatrix}_f = \begin{bmatrix} \cos\theta & -\sin\theta & 0 \\ \sin\theta & \cos\theta & 0 \\ 0 & 0 & 1 \end{bmatrix} \cdot \begin{bmatrix} Xd \\ Yd \\ 1 \end{bmatrix}_f \quad \cdots\cdots (26)$$

Therefore, the part mounting position is given on the robot coordinate system r as follows:

[Equation 33]

$$\begin{bmatrix} Xr \\ Yr \\ 1 \end{bmatrix}_s = \begin{bmatrix} a & -b & \beta x \\ b & a & \beta y \\ 0 & 0 & 1 \end{bmatrix} \cdot \begin{bmatrix} Xn \\ Yn \\ 1 \end{bmatrix}_{nc} \quad \cdots\cdots (27)$$

[Equation 34]

$$\begin{bmatrix} Xr \\ Yr \\ 1 \end{bmatrix}_r = \begin{bmatrix} ap & bp & \beta px \\ cp & dp & \beta py \\ 0 & 0 & 1 \end{bmatrix}^{-1} \cdot \begin{bmatrix} Xr \\ Yr \\ 1 \end{bmatrix}_s \quad \cdots\cdots (28)$$

$(Xn, Yn)_{nc}$ represents the part mount position based on the NC coordinate system.
Further, the position of the part on the robot coordinate system after the mount angle adjustment is given as follows:

[Equation 35]

$$\begin{bmatrix} Xda \\ Yda \\ 1 \end{bmatrix}_r = \begin{bmatrix} e & f & X_c \\ g & h & Y_c \\ 0 & 0 & 1 \end{bmatrix} \cdot \begin{bmatrix} Xda \\ Yda \\ 1 \end{bmatrix}_f \quad \cdots\cdots(29)$$

$(Xda, Yda)_f$ represents the position of the part after the rotational correction which contains the inclination of the board on the fixed camera coordinate system f.

At this time, when the mounting head is located at $(X,Y)_r$, the mount position of the mounting head is given as follows:

[Equation 36]

$$\therefore \begin{bmatrix} Xa \\ Ya \\ 1 \end{bmatrix}_r = \begin{bmatrix} Xr \\ Yr \\ 1 \end{bmatrix}_r - \left( \begin{bmatrix} Xda \\ Yda \\ 1 \end{bmatrix}_r - \begin{bmatrix} X \\ Y \\ 1 \end{bmatrix}_r \right) \quad \cdots\cdots(30)$$

Finally, in step ST15, the mounting head is moved to the mount position given from the equation (30), whereby the electrical part concerned is moved to a desired mount position of the mounting board 11 and the electrical part is mounted on the mounting board 11.

As described above, the mounting of the electrical part onto the mounting board 11 is completed.

As described above, according to this embodiment, each coordinate system is calibrated by the coordinate system of the mounting head, whereby the calibration of the part mounting apparatus can be systematized. Therefore, the final mounting precision can be easily estimated at the design step of the part mounting apparatus, and desired mounting precision can be surely achieved. In addition, the calibration method is widely usable to support new models, and thus the development time of the new models of the part mounting apparatus can be shorted and the developing cost can be reduced.

In the above embodiment, repetitive positioning precision is required with respect to the position of the mounting head and the rotational angle of the part on the basis of the mounting head, and repetitive precision is required with respect to the image recognition of the fixed camera 14 and the board camera 15. Further, it is unnecessary that the two coordinate axes of the robot coordinate system intersect to each other at 90 degrees, however, linearity of the axes is required to be ensured.

In the robot coordinate system, the reference board coordinate system, the board camera coordinate system and the fixed camera coordinate system, the coordinate axis of each coordinate system may face in any direction, however, the coordinate planes on which the two coordinate axes of the respective coordinate systems are located must be parallel to each other.

In the above embodiment, the mounting head recognizes the mounting board and mounts a part thereon. However, the present invention is not limited to this embodiment, and the present invention may be applied to a part mounting apparatus in which a board is located on a mounting head, a board camera is fixedly disposed, and the mounting head moves the mounting board relatively to a fixedly disposed electrical part, whereby the electrical part concerned is relatively moved to a predetermined position of the mounting board.

Further, in the above embodiment, the mounting head is designed in a so-called XY type in which the mounting head is moved in the XY directions. However, the present invention is not limited to this embodiment, and it may be designed in a so-called SCARA type or vertical joint type. In this case, the calibration of each coordinate system is carried out for XY coordinate which is virtually constructed.

Still further, the fixed camera and the board camera comprising CCD cameras are used as the part recognition portion and the board recognition portion in order to recognize the electrical part and the mounting board. However, the present invention is not limited to this embodiment, and a sensor such as an LED sensor or a laser sensor may be used insofar as it can detect the coordinate position and rotation of the coordinate system.

As described above, according to the present invention, there can be provided a widely usable calibration method which can enhance the mounting precision and can be easily developed by systematizing the calibration of the mounting position of the mounting head to the mounting board.

**Claims**

1.    A calibrating method for a part mounting apparatus including a support table on which a mount board is supported, a part supply portion for successively supplying electrical parts, a mounting head for feeding an electrical part from the part supply portion to a predetermined position of the mount board on the support table, a part recognition portion which is fixedly disposed so as to detect the position of an electrical part in the part supply portion on the basis of image recognition, and a board recognition portion which is provided to the mounting head so as to detect the position of the mount board on the support table on the basis of image recognition, characterized by comprising:

a first step for calibrating the coordinate system of said part recognition portion on the basis of the coordinate system of said mounting head;

a second step for calibrating the coordinate system of said board recognition portion on the basis of the coordinate system of said mounting head;

a third step for calibrating the coordinate system of a reference board on the basis of the coordinate system of said mounting head;

a fourth step for correcting the origin of the coordinate system of said part recognition portion on the basis of the coordinate system of said mounting head; and

a fifth step for calculating the rotational center position of said mounting head.

2.    The calibrating method as claimed in claim 1, wherein said first step mounts a recognition target by said mounting head and recognizes the recognition target by said part recognition portion on the basis of three points which are not located on any straight line on the plane parallel to the board surface, thereby calibrating the coordinate system of said part recognition portion on the basis of the coordinate system of said mounting head.

3.    The calibrating method as claimed in claim 1, wherein said second step recognizes the fixed point on said board by said board recognition portion on the basis of three points which are not located on any straight line on the plane parallel to the board surface of said board recognition portion, thereby calibrating the coordinate system of said board recognition portion on the basis of the coordinate system of said mounting head.

4.    The calibrating method as claimed in claim 1, wherein said third step recognizes, by said board recognition portion, three points which are not located on a known straight line on a reference board supported on said support table, thereby calibrating the coordinate system of the reference board on the basis of the coordinate system of said mounting head.

5.    The calibrating method as claimed in claim 1, wherein said fourth step recognizes one recognition hole fixedly disposed on a board jig on the basis of the coordinate system of a fixed recognition portion and a part recognition portion or a reference board, thereby calibrating the origin of the coordinate system of said fixed recognition portion on the basis of the coordinate system of said mounting head.

6.    The calibrating method as claimed in claim 1, wherein said fifth step mounts a recognition target by said mounting head and recognizes the recognition target while rotating the recognition target around the vertical axis by every predetermined angle, thereby calibrating the rotational center position of said mounting head in the coordinate system of said part recognition portion.

EP 1 065 917 A2

# FIG.1

10

12

14

13

15

ALIGNMENT MARK

11

16

# FIG.2

```
          ┌──────────┐
          │  START   │
          └──────────┘
               │
               ▼
┌─────────────────────────────────┐
│ CALIBRATION 1 OF ROBOT          │
│ COORDINATE SYSTEM r AND FIXED   │──ST1
│ CAMERA COORDINATE SYSTEM f      │
└─────────────────────────────────┘
               │
               ▼
┌─────────────────────────────────┐
│ CALIBRATION OF ROBOT            │
│ COORDINATE SYSTEM r AND BOARD   │──ST2
│ CAMERA COORDINATE SYSTEM p      │
└─────────────────────────────────┘
               │
               ▼
┌─────────────────────────────────┐
│ CALIBRATION OF ROBOT COORDINATE │
│ SYSTEM R AND REFERENCE BOARD    │──ST3
│ COORDINATE SYSTEM s             │
└─────────────────────────────────┘
               │
               ▼
┌─────────────────────────────────┐
│ CALIBRATION 2 OF ROBOT          │
│ COORDINATE SYSTEM r AND FIXED   │──ST4
│ CAMERA COORDINATE SYSTEM f      │
└─────────────────────────────────┘
               │
               ▼
┌─────────────────────────────────┐
│ CALCULATION OF DISTANCE FROM    │
│ FIXED CAMERA TO ROTATION        │──ST5
│ CENTER OF MOUNTING HEAD         │
└─────────────────────────────────┘
               │
               ▼
          ┌──────────┐
          │   END    │
          └──────────┘
```

# FIG.3

XY
ROBOT
COORDINATE
SYSTEM
r

(0,0)f

(0,0)r

BOARD
CAMERA
COORDINATE
SYSTEM
p

A

# FIG.4

# FIG.5

+y

BOARD RECOGNITION CAMERA
COORDINATE SYSTEM p

+Y

+y

(0,0)p +y +x

PART RECOGNITION
FIXED CAMERA
COORDINATE SYSTEM f

(Xa,Ya)r

(0,0)s

+x

$\beta$p

(0,0)f +x

(Xc,Yc)r

(0,0)r

XY ROBOT
COORDINATE
SYSTEM r +X

REFERENCE
BOARD
COORDINATE
SYSTEM s

# FIG.6

START

RECOGNIZE ALIGNMENT MARK ON BOARD BY BOARD CAMERA — ST11

SUCTION OF PART BY NOZZLE — ST12

POSITION PART ON FIXED CAMERA AND RECOGNIZE PART — ST13

CORRECTION CALCULATION — ST14

PART MOUNTING — ST15

END

# FIG.7

(Xr1,Yr1)p

θp

(Xn1,Yn1)nc

+y

(Xr2,Yr2)p

+x

(Xn2,Yn2)nc

NC COORDINATE
SYSTEM nc

(0,0)nc

# FIG.8

+Y FIXED CAMERA
COORDINATE SYSTEM f

(Xda,Yda)

(Xd,Yd)

θ

θd

+X

ROTATIONAL
CENTER (Xrc,Yrc)